# FASCICULE DE BREVET EUROPEEN

(11) **EP 1 896 629 B1**
(45) Date de publication et mention de la délivrance du brevet: **01.12.2010**
(21) Numéro de dépôt: 06778689.7
(22) Date de dépôt: 21.06.2006
(51) Int. Cl.: C23C 16/32, C23C 16/40, H01L 21/316, H01L 21/314

(54) **PROCEDE DE FORMATION D'UN FILM DIELECTRIQUE ET NOUVEAUX PRECURSEURS POUR LA MISE EN OEUVRE DE CE PROCEDE**
VERFAHREN ZUR ERZEUGUNG EINER DIELEKTRISCHEN FOLIE UND NEUARTIGE VORLÄUFER ZUR IMPLEMENTIERUNG EINES SOLCHEN VERFAHRENS
METHOD FOR FORMING A DIELECTRIC FILM AND NOVEL PRECURSORS FOR IMPLEMENTING SAID METHOD

(30) Priorité: 21.06.2005 FR 0551675
(43) Date de publication de la demande: 12.03.2008
(73) Titulaire: L'AIR LIQUIDE, Société Anonyme pour l'Etude et l'Exploitation des Procédés Georges Claude, 75007 Paris (FR)
(72) Inventeur: DUSSARRAT, Christian, Tsukuba-Shi, Ibaraki 305-0035 (JP)
(74) Mandataire: Conan, Philippe Claude
(86) Numéro de dépôt international: PCT/FR2006/001495
(87) Numéro de publication internationale: WO 2006/136741

(56) Documents cités:
- EP-A- 0 533 129
- US-A- 4 923 716
- US-A- 5 744 196
- US-A1- 2001 026 849
- US-B1- 6 245 690
- WROBEL A M ET AL: "FILM-FORMING PRECURSORS IN PLASMA CHEMICAL VAPOR DEPOSITION USING TETRAMETHYL-1,3-DISILACYCLOBUTANE AS A SOURCE COMPOUND" JOURNAL OF CHEMICAL VAPOR DEPOSITION, TECHNOMIC PUBLISHING, LANCASTER, PA, US, vol. 4, no. 2, octobre 1995 (1995-10), pages 87-110, XP009058034 ISSN: 1056-7860
- MAIER, G. ET AL: "Hetero-.pi.-systems. XVI. Alkoxysilylene (alkoxysilanediyl)" JOURNAL OF ORGANOMETALLIC CHEMISTRY , 366(1-2), 25-38 CODEN: JORCAI; ISSN: 0022-328X, 1989, XP002361143
- PATENT ABSTRACTS OF JAPAN vol. 2003, no. 12, 5 décembre 2003 (2003-12-05) -& JP 2004 288979 A (L'AIR LIQUIDE SA POUR L'ETUDE & L'EXPLOITATION DES PROCEDE S GEORGES C), 14 octobre 2004 (2004-10-14)
- LASKA, JADWIGA E. ET AL: "Synthesis, Strain, Conformational Analysis, and Molecular and Crystal Structures of 1,1,4,4-Tetraphenyl-1,4-disilacyclohexane and 1,1,4,4-Tetraphenyl-1,4-disilacyclohexa-2, 5-diene" ORGANOMETALLICS , 17(10), 2018-2026 CODEN: ORGND7; ISSN: 0276-7333, 1998, XP002361144
- MAIER G ET AL: "Hetero-.pi.-systems. 13. 1,4-Disilabenzene. Dimethoxysilyls as ideal synthesis building blocks" TETRAHEDRON LETTERS, ELSEVIER, AMSTERDAM, NL, vol. 26, no. 34, 1985, pages 4079-4082, XP002361145 ISSN: 0040-4039

## Description

La présente invention concerne un procédé de formation d'un film diélectrique utilisable dans la fabrication des semi-conducteurs.

Au cours de la fabrication des circuits intégrés , par exemple des circuits intégrés pour des applications grand public ou des microprocesseurs, on réalise un très grand nombre d'étapes successives de dépôts sélectifs sous vide de différentes couches de produits, ces étapes successives étant elles-mêmes séparées par des étapes de nettoyage de la galette de silicium (aujourd'hui d'un diamètre de 300 mm) sur laquelle sont empilées ces couches successives.

On distingue généralement deux types de couches déposées successivement :
le premier type de dépôt (ou « FEOL » en langue anglaise) consiste essentiellement à déposer une multitude de couches successives pour la création de composants actifs du type transistors à effets de champs (dépôt de couche photosensible, masquage, exposition aux rayons UV, nettoyage, dopage de la couche monocristalline selon le type de transistor réalisé puis dépôt des électrodes puis des contacts électriques sur les zones de drain, source et grille de chaque transistor, ...etc.)

Le second type de dépôt (ou « BEOL » en langue anglaise) consiste à créer un réseau d'interconnexions électriques entre les différents contacts électriques, notamment des semi-conducteurs réalisés lors des différentes étapes du premier type de dépôt, mais également à créer dans le cas notamment de fabrication de mémoires à accès aléatoires, les capacités nécessaires à l'enregistrement d'informations sous forme numérique. Dans ces deux types d'application, on réalise essentiellement des dépôts de couches métalliques et/ou conductrices électriquement et des dépôts de couches diélectriques à très faible constante diélectrique séparant ces couches conductrices ainsi que des dépôts de couches barrières évitant notamment la diffusion dans les couches inférieures ou latéralement lorsqu'on réalise la gravure d'une ou plusieurs couches inférieures diélectrique ou conductrice à 1 aide de produits chimiques liquides ou sous forme gazeuse et dont on souhaite une action sélective.

La présente invention concerne essentiellement la réalisation des couches diélectriques dans le cas des seconds types de dépôts envisagés ci-dessus(« BEOL »).

Pour augmenter la densité d'intégration des circuits et corrélativement leur puissance de traitement d'informations sur un volume de plus en plus réduit, il convient de diminuer les dimensions (épaisseur, longueur) des lignes d'interconnexion, ce qui permet de les rapprocher les unes des autres et de gagner ainsi en volume, à condition cependant que les couches diélectriques qui séparent, d'une part les connexions électriques de deux couches successives, dans une vue verticale du circuit (couches encore appelées couches diélectriques intercalaires « ILD » ou « interlayer dielectric » en langue anglaise) et d'autre part les interconnexions métalliques situées dans un même plan horizontal du circuit (couches encore appelées couches diélectriques intermétalliques (« IMD » ou « intermetaldielectric » en langue anglaise), aient des propriétés diélectriques améliorées (constante diélectrique encore plus faible) pour permettre une isolation électrique suffisante entre deux lignes de connexions plus rapprochées, mais surtout pour diminuer la constante de temps des circuits d'interconnexion(constante de temps dont l'élément capacitif a une valeur d'autant plus faible que le diélectrique a une constante faible mais une valeur d'autant plus forte au contraire que l'on rapproche ses électrodes).

Les contraintes toujours croissantes pour l'exécution du câblage électrique d'interconnexion dans la partie supérieure(communément appelée « BEOL ») du circuit intégré (voir ci-avant) a conduit récemment à d'importants progrès technologiques :
Le cuivre a remplacé l'aluminium comme métal d'interconnexion du fait de sa meilleure conductivité électrique. Ceci a conduit à l'adoption d'un nouveau procédé de dépôt métallique selon une technologie dite « dual-damascène », au cours duquel on créée une tranchée par gravure sélective d'une résine photosensible, tranchée que l'on vient ensuite remplir de cuivre par un procédé d'électrodéposition.

Par ailleurs, les films en SiOC (c'est-à-dire en oxyde de silicium dopé au carbone) sont désormais couramment utilisés pour remplacer le dioxyde de silicium utilisé auparavant comme diélectrique dans les couches intercalaires et les couches intermétalliques d'un circuit intégré.

Enfin, dans le but d'abaisser encore la constante diélectrique de ces couches, ont été introduits les diélectriques à structure poreuse. En effet, les films diélectriques de SiO2 déposés en phase vapeur (CVD), à partir d'un composé de silicium et d'oxygène, ont une constante diélectrique d'environ 4.0. On a cherché à abaisser la constante diélectrique desdites couches afin de conserver à celles-ci de bonnes propriétés isolantes tout en réduisant leur épaisseur. Les films à faible constante diélectrique (appelés « low-k » en langue anglaise) c'est-à-dire constitués de matériaux ayant une constante diélectrique inférieure à 4, peuvent être produits de multiples façons, en particulier en dopant l'oxyde de silicium avec des ligands organiques pour obtenir des films ayant une constante diélectrique comprise entre environ 2.7 et 3.5. Cette approche, dans laquelle on utilise des ligands organiques terminaux, c'est-à-dire non connectés au réseau de la molécule du matériau final, entraîne la réduction du nombre de liaisons(ou "ponts") oxygène entre deux siliciums du type -Si-Q-Si-, ce qui réduit donc la cohésion de la structure de la chaîne, et par conséquent diminue les propriétés mécaniques de ce type de matériau comparées à celles de SiO2. Ces propriétés mécaniques sont pourtant critiques pour éviter la délamination des couches successives du circuit intégré lors du processus de polissage effectué dans une étape ultérieure de la fabrication du circuit (procédé de polissage chimique et mécanique appelé « CMP » en langue anglaise). Un autre paramètre important à considérer dans la réalisation des couches diélectriques est l'existence possible de forces de tensions internes dans la structure du matériau constituant le film : la majeure partie de la structure électronique est créée à une température de l'ordre de 300 à 450°C. Quand l'ensemble est refroidi, les matériaux, y compris le substrat de silicium, le réseau de cuivre, et les films diélectriques se contractent différemment du fait de leurs coefficients de dilatations différents. Ceci créée une importante source de contraintes mécaniques qui dégradent la couche la plus fragile de SiOC à faible constante diélectrique.

Pour déposer ces couches de SiOC à faible constante diélectrique, il existe actuellement deux procédés :
- le procédé de dépôt chimique en phase vapeur qui utilise des précurseurs du type diméthyldiméthoxy silane (DMDMOS),tétraméthylsilane(4MS),tétraméthylcyclotétrasiloxane(TMCTS), octaméthylcyclotétrasiloxane(OMCTS), 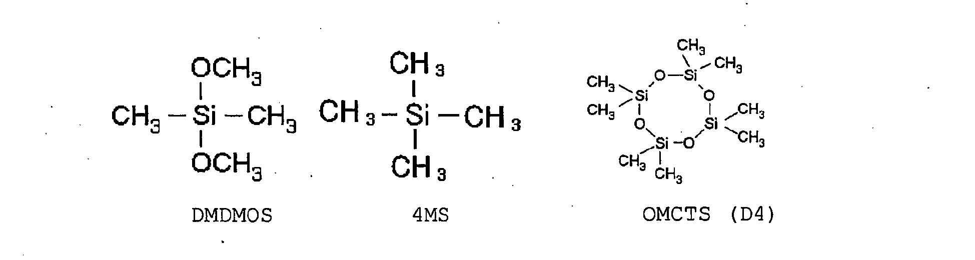
- le procédé de dépôt par centrifugation (désigné communément par le terme « spin-on » en langue anglaise) qui utilise des siloxanes pour former des films tels que le méthyle-silsesquioxane(MSQ) ou l'hydrogène silsesquioxane (HSQ) dans un solvant approprié.

Lors du dépôt des couches d'interconnexion métalliques et des couches de SiOC qui les séparent et les isolent, il est parfois nécessaire de déposer également une couche mince de SiC (appelée « etch-stop » en langue anglaise) permettant de stopper le passage des produits chimiques lors d'une étape de gravure d'une couche déposée ultérieurement au-dessus de celle-ci. Le carbure de silicium est un matériau isolant réfractaire ayant une constante diélectrique d'environ 5, ce qui augmente bien évidemment la constante diélectrique moyenne de la couche diélectrique séparant ainsi deux couches métalliques d'interconnexion.

On cherche à l'heure actuelle à réduire la constante diélectrique de ces couches barrières de gravure, notamment en SiC.

La présente invention a pour but d'améliorer notamment les propriétés mécaniques des couches diélectriques, notamment à faible constante diélectrique, utilisées en particulier comme couches diélectriques intercalaires ou comme couches diélectriques intermétalliques au niveau dit « BEOL » d'interconnexion électrique des composants d'un circuit intégré. Pour répondre au problème technique ainsi posé, la présente invention consiste à utiliser des précurseurs de couches de matériau diélectrique comportant au moins un atome de carbone et au moins deux atomes de silicium les atomes de carbone et de silicium formant une chaîne du type-Si-Cn-Si- avec au moins un atome de carbone relié à deux atomes de silicium, avec n supérieur ou égal à 1, de préférence inférieur ou égal à 5.

Selon un mode de réalisation, on pourra utiliser des précurseurs de type alkoxysilyl alcane (RⁱO)₃Si(-CRⁱ₂)ₙ-Si(ORⁱ)₃, formule dans laquelle chaque radical Rⁱ peut être choisi parmi l'hydrogène ou une chaîne carbonée, par exemple du type alkyl, aryle,... etc avec un nombre d'atomes de carbone compris entre 1 et 5 de préférence 1 ou 2 tels que, par exemple, le BTESE (bis(triethoxysilyl)ethane) de formule (EtO)₃Si-CH₂-CH₂-Si(OEt)₃, avec Et = C₂H₅ > dont la constante diélectrique et les propriétés mécaniques sont sensiblement améliorées par rapport aux couches réalisées avec les précurseurs de l'art antérieur.

Selon le mode préféré de réalisation, l'invention consiste à utiliser des molécules cycliques, permettant notamment de produire des couches diélectriques poreuses contenant des cycles et choisies notamment parmi l'une des familles suivantes: 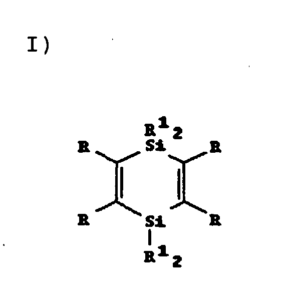 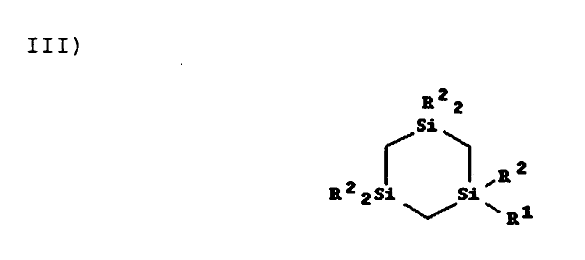 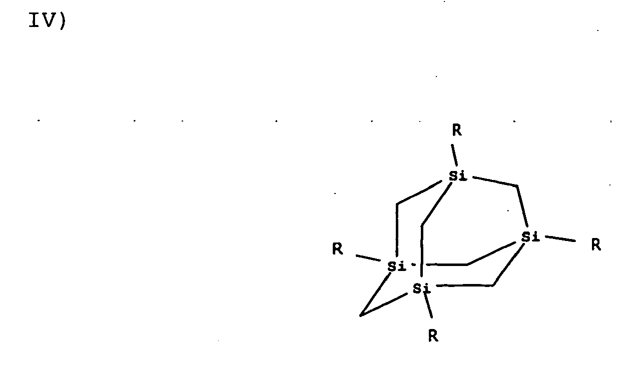 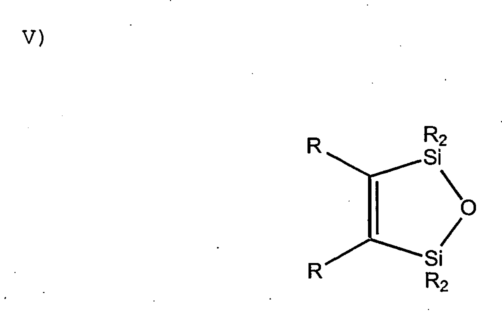 R, R¹, R², étant choisis parmi l'hydrogène, les chaînes carbonées linéaires et/ou cycliques tels que les alkyls, les aryles,...etc ou les alkoxides.

De préférence, on choisira, selon l'invention, les molécules telles que le « double-DMDMOS » (formule I dans laquelle R = H et R¹ = -O-CH₃). Plus préférentiellement encore, R sera choisi parmi le groupe suivant : H, -CH₃ ou un groupe alkyle en général, R¹ étant choisi parmi-O-CH₃, ou plus généralement un alkoxide ou une amine. On pourra choisir également d'autres ligands pour R¹, tels que Cl, Me ou H.

Toutes ces molécules contiennent au moins un atome de carbone entre deux siliciums. De préférence, ces molécules forment un cycle ou une cage (structure tridimensionnelle illustrée par la structure moléculaire IV) contenant au moins une chaîne Si-C-Si (avec une possibilité de plusieurs atomes de carbones entre deux atomes de Si). Ce type de molécules tridimensionnelles favorise la formation de pores dans les films obtenus, assurant ainsi à la fois une cohésion structurale beaucoup plus forte que les molécules avec des groupes alkyls terminaux, et une réduction très significative de la constante diélectrique.

Ces différents précurseurs peuvent être synthétisés par exemple par la réaction du dichlorosilylène : -SiCl₂ avec des hydrocarbures ayant des liaisons Π, tels que l'acétylène ou le butadiène. La source de dichlorosilylène peut être l'hexachlorodisilane, ou le trichlorosilane. Elle peut être soit formée à température élevée par décomposition de l'hexachlorodisilane (HCD), ou à basse température à partir d'une solution contenant par exemple une amine tertiaire comme catalyseur (tel la triméthylamine). La synthèse des molécules de formule I sera par exemple réalisée en deux étapes :
Une première étape commune à toutes les molécules selon la réaction :
   Si₂Cl₆ (ou un mélange de chloropolysilanes) + éthylène → Cl₂Si-(CH=CH)₂-SiCl₂

L'acétylène, le butadiène, le benzène... mènent a ce type de réaction suivant le même principe: le dichlorosilylène : SiCl₂ réagit avec la liaison Π. D'une manière générale, toutes les espèces insaturées sont des candidats potentiels pour la synthèse de ce type de molécule. La deuxième étape est spécifique au type de molécule considéré:
Cl₂Si-(CH=CH)₂-SiCl₂ + MeOH → (MeO)₂Si-(CH=CH)₂-Si(OMe)₂ (pour la molécule I avec R¹= OMe)
Cl₂Si-(CH=CH)₂-SiCl₂ + LiAlH₄ or NaBH₄ → H₂Si-(CH=CH)₂-SiH₂ (pour la molécule I avec R¹= H)
Cl₂Si-(CH=CH)₂-SiCl₂ + catalyseur de Speyer → Me₂Si-(CH=CH)₂-SiMe₂ (pour la molécule I avec R¹=Me).

On peut également obtenir l'équivalent fluoré (par exemple, F₂Si-(CH-CH)₂-SiF₂) avec cette méthode, cet équivalent fluoré pouvant être utilisé pour former des films à faible constante diélectrique.

D'une manière générale, l'homme du métier trouvera toutes les informations nécessaires à la synthèse de ces différents produits par exemple dans la publication de Atwell et Weyenberg, J.Am. Chem. Soc., 3438, 90, 1968.

Selon l'invention, les procédés et les compositions satisfont à la nécessité, pour l'homme du métier, de former une couche mince isolante ayant d'excellentes propriétés électriques, mécaniques ainsi qu'une uniformité élevée. Les films déposés selon l'invention sont réalisés en vaporisant une source de précurseurs à faible constante diélectrique consistant en un ou une pluralité de précurseurs pour engendrer une source de vapeur desdits précurseurs et en distribuant les vapeurs de ces précurseurs vers une chambre de dépôt dans laquelle les précurseurs sont décomposés thermiquement et/ou par la mise en oeuvre d'un plasma, formant un film de la composition désirée. Le film est formé sur un ou plusieurs substrats en une seule étape de formation sans qu'il ne soit nécessairement requis un traitement thermique ultérieur. Le film à faible constante diélectrique qui en résulte aura la composition désirée de façon a avoir un faible courant de fuite. En général, les précurseurs utilisés dans le procédé pour le dépôt de films à la stoechiométrie désirée selon l'invention seront en phase liquide, par exemple un précurseur liquide ou une solution liquide de précurseur dans un solvant tel qu'un hydrocarbure. Le précurseur en phase liquide est injecté dans un système de vaporisation, dont le débit est mesuré et contrôlé préalablement. Ce précurseur vaporisé est conduit dans la chambre de dépôt où le dépôt est réalisé à une pression de l'ordre du Torr (généralement moins de 200 Pascals) et à une température comprise généralement entre 0°C et 450°C, de préférence entre 200°C et 400°C. La chambre est éventuellement équipée d'un plasma permettant d'augmenter significativement la vitesse de dépôt. Généralement, mais pas nécessairement, un co-réactant est également introduit dans la chambre de dépôt de manière à réagir avec le précurseur, ce co-réactant étant de préférence un oxydant (oxygène, ozone, vapeur d'eau peroxyde d' hydrogène, alcools...etc).

Selon l'invention, on réalise le dépôt du film par une technique de dépôt chimique en phase vapeur dite CVD, telle que la technique dite PECVD ou la technique de CVD thermique, techniques bien connues de l'homme du métier, à partir d'au moins un précurseur seul ou en combinaison avec un réactant, de préférence une source d'oxygène. D'une manière générale, l'homme du métier optimisera la source de précurseur en abaissant la constante diélectrique (k) aussi bas que possible tout en maintenant un niveau acceptable en terme de propriétés mécaniques.

Préférentiellement, le précurseur est une molécule cyclique contenant un ou plusieurs atomes de carbones entre deux atomes de siliciums.

Selon un autre aspect de l'invention, la molécule est un disilane, qui se décompose par excitation thermique

ou plasma et qui réagit avec une chaîne carbonée insaturée (contenant des liaisons Π) pour former des espèces intermédiaires contenant des liaisons -Si-C, préférentiellement pour former des espèces intermédiaires contenant un carbone ou une chaîne carbonée (linéaire ou cyclique) liée à deux atomes de siliciums, au cours de la fabrication du film à faible constante diélectrique. Préférentiellement, les carbones formant une chaîne carbonée reliant les siliciums auront au moins une double liaison du fait que la double liaison C=C est plus forte qu'une liaison simple C-C: ceci permet d'obtenir des films à faible constante diélectrique ayant des propriétés mécaniques améliorées par rapport aux films obtenus à partir d'une chaîne d'atomes de carbone ne comportant que des liaisons simples.

En outre, les molécules décrites ci-dessus qui ne contiennent pas d'atomes d'oxygène ont une structure moléculaire qui convient bien au dépôt d'une couche mince de SiC utilise comme barrière de gravure ("etch stop") dans la partie dite « BEOL » du circuit intégré.

Préférentiellement, le précurseur de SiC a basse constante diélectrique est une molécule cyclique contenant un ou plusieurs atomes de carbones lies a deux siliciums, mais ne contenant pas d'oxygène.

Préférentiellement, les carbones formant une chaîne carbonée reliant les siliciums ont une double liaison (dans la mesure où une double liaison C=C est plus difficile à

rompre qu'une liaison simple C-C), ce qui permet d'obtenir plus facilement de hautes propriétés mécaniques dans les films résultants.

Selon un autre aspect de la présente invention, le précurseur SiC à basse constante diélectrique sera un disilane qui ne contient pas d'oxygène, qui se décompose par excitation thermique ou plasma et qui réagit avec une chaîne carbonée insaturée (contenant des liaisons Π (pi)) pour former des espèces intermédiaires contenant des liaisons Si-C, préférentiellement pour former des espèces intermédiaires contenant un carbone ou une chaîne carbonée liées à deux siliciums, au cours de la fabrication du film SiC.

Selon un autre aspect, l'invention concerne les couches diélectriques formées à partir des précurseurs mentionnés ci-dessus, ainsi que l'utilisation de ces précurseurs pour la réalisation des couches diélectriques à faibles constantes, en particulier l'utilisation du produit de la revendication 7 comme précurseur.

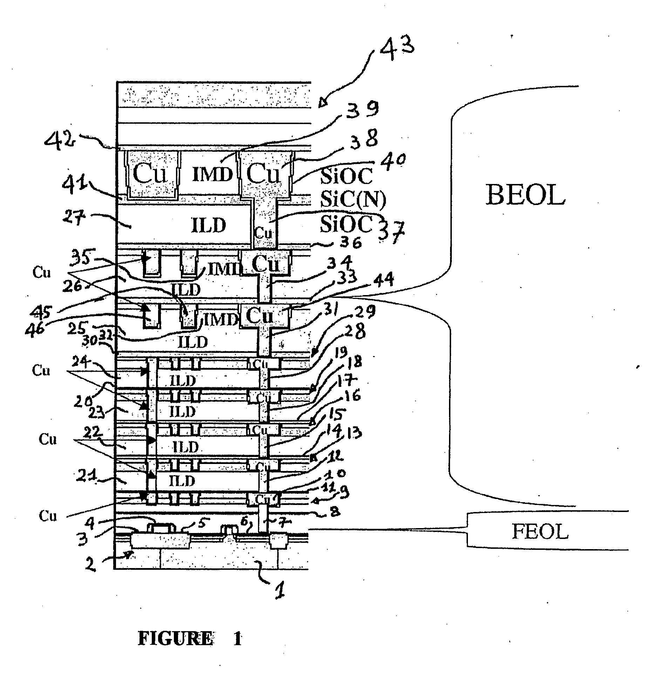

L'invention sera mieux comprise à l'aide des exemples de réalisation suivants, donnés à titre non limitatif conjointement avec la figure qui représente une vue en coupe d'un circuit intégré avec ses différentes couches dans ses parties dites « FEOL » et « BEOL ».

Sur la figure, la tranche de silicium monocristallin 1 sur laquelle sont réalisés les différents transistors MOS avec leurs interconnexions et leur couche de protection représente la partie dite « FEOL », du circuit intégré, l'ensemble des couches supérieures au-delà de la couche barrière 8 représentant la partie dite « BEOL » dans laquelle on réalise les interconnexions électriques entre les différents circuits de la partie « FEOL » comme expliqué ci-avant.

Sur le substrat monocristallin 1, est réalisé un circuit intégré, par exemple, représenté par 2, sur lequel on a représenté schématiquement les contacts de drain (3), de grille (4) et de source (5), ainsi que les interconnexions dans le niveau horizontal de ce circuit représentées par (6). Une interconnexion en tungstène ou cuivre vertical (7) relie dans la vue en coupe de la figure, une connexion (6) à travers la couche barrière (8) à l'étage supérieur d'interconnexion (9) dans lequel la connexion du cuivre (10), vue en coupe, s'étend en fait perpendiculairement au plan de la figure, et est elle-même reliée à la connexion (12) à l'étage supérieur puis à la connexion (15) puis aux connexions (15, 18, 28, 31, 34, 37) pour se terminer à la connexion centrale (38) dans la partie supérieure d'interconnexion du circuit intégré.

Entre les différents étages d'interconnexion 9, 13, 16, 19, 29, ...etc. se trouvent les couches barrières respectives 11, 14, 17, 20, 30, 33, 36, 41... séparant des connexions métalliques en cuivre dans différents plans horizontaux les unes des autres, par l'intermédiaire de couches diélectriques appelées ILD telles que 21, 22, 23, 24, 25, 26, 27. Dans un ensemble de couches de même étage, tel que par exemple l'ensemble qui se trouve entre les deux couches barrières 30 et 33, on trouve dans la partie inférieure une couche diélectrique ILD permettant l'isolement entre deux couches successives horizontales d'interconnexion en cuivre, et entre les parois latérales de connexion en cuivre telles que 44, 45, 46 et disposer une couche diélectrique appelée IMD, afin d'isoler électriquement les connexions électriques en cuivre telles que 44 et 45.

Dans l'exemple de la figure, les couches ILD et IMD sont réalisées par exemple à l'aide du même diélectrique SiOC.

Les couches barrières étant en général des couches de SiC ou SiN.

L'invention se rapporte à la formation de ces couches diélectriques intercalaires, ILD, ainsi qu'à la formation des couches intermétalliques diélectriques, IMD.

## Revendications

1. Procédé pour former une couche diélectrique à faible constante diélectrique et utilisable pour séparer des interconnexions métalliques notamment lors de la fabrication de circuits intégrés, ladite couche comportant du SiC et/ou du SiOC, et étant obtenue à partir d'au moins un précurseur comportant au moins une molécule cyclique choisie parmi l'une des familles suivantes: 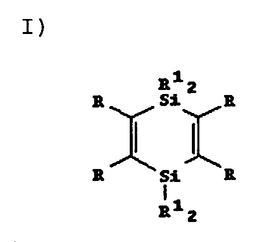 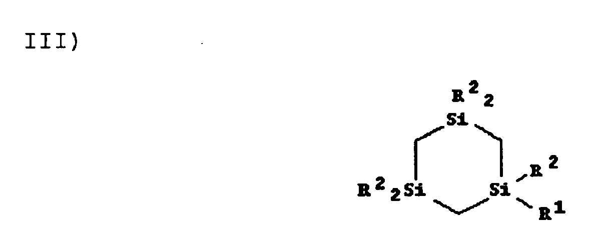 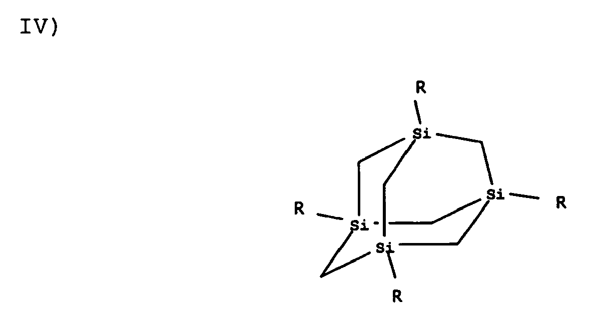 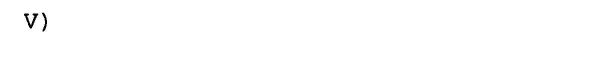 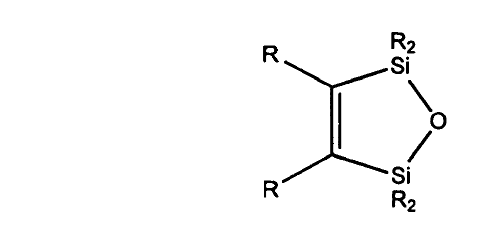 R, R¹, R², étant choisis parmi l'hydrogène, les chaînes carbonées linéaires et/ou cycliques tels que les alkyls, les aryles, ou les alkoxides, **caractérisé en ce que** le précurseur est vaporisé pour former une source de précurseur vaporisé qui est amené dans un réacteur de dépôt sous vide dans lequel est placé un substrat préalablement amené à une température T, de manière à former un film diélectrique de composition finale désirée.

2. Procédé selon la revendication 1, **caractérisé en ce que** la molécule cyclique est du double DMDMOS de Formule I) dans laquelle R=H et R¹= R² =-O-CH₃.

3. Procédé selon la revendication 1, **caractérisé en ce que** R est un radical alkyle, de préférence -CH₃, et R¹= -O-CH₃,

4. Procédé selon l'une des revendications 1 à 3, **caractérisé en ce que** la chaîne carbonée reliant les atomes de silicium comporte au moins une double liaison.

5. Procédé selon l'une des revendications 1 à 4, **caractérisé en ce que** l'on injecte également de l'azote et/ou un autre gaz inerte dans le réacteur.

6. Procédé selon l'une des revendications 1 à 5, **caractérisé en ce que** l'on injecte également de l'oxygène dans le réacteur, de manière à former une couche SiOC.

7. Utilisation de la molécule de formule générale : 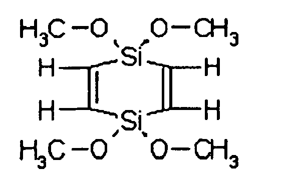 comme précurseur notamment de SiC et SiOC.

## Claims

1. Process for forming a low-k dielectric layer that can be used to separate metal interconnects, in particular during the fabrication of integrated circuits, said layer comprising SiC and/or SiOC and being obtained from at least one precursor containing at least one cyclic molecule chosen from one of the following families: 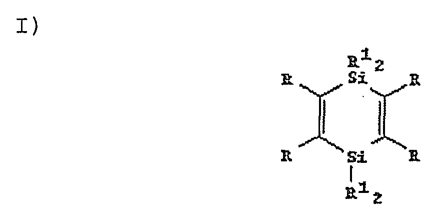 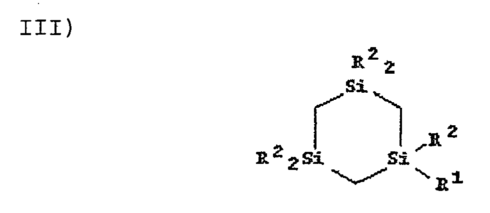 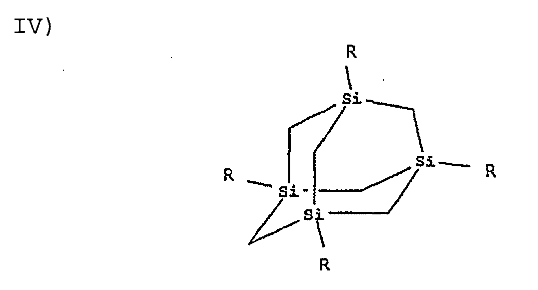 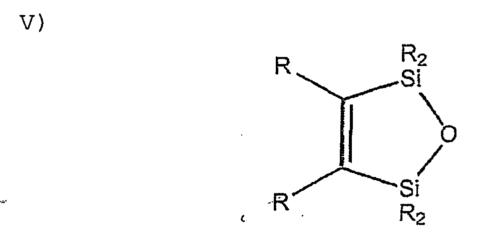 R, R¹, R² being chosen from hydrogen, linear and/or cyclic carbon chains, such as alkyls, aryls or alkoxides **characterized in that** the precursor is vaporized to form a source of vaporized precursor, which is taken into a vacuum deposition reactor in which a substrate, brought beforehand to a temperature T, is placed so as to form a dielectric film with the desired final composition.

2. Process according to Claim 1, **characterized in that** the cyclic molecule is double DMDMOS of formula I) in which R = H and R¹ = R² = -O-CH₃.

3. Process according to Claim 1, **characterized in that** R is an alkyl radical, preferably -CH₃, and R¹ = O-CH₃.

4. Process according to one of Claims 1 to 3, **characterized in that** the carbon chain connecting the silicon atoms contains at least one double bond.

5. Process according to one of Claims 1 to 4, **characterized in that** nitrogen and/or another inert gas is also injected into the reactor.

6. Process according to one of Claims 1 to 5, **characterized in that** oxygen is also injected into the reactor so as to form an SiOC layer.

7. Use of the molecule of general formula: 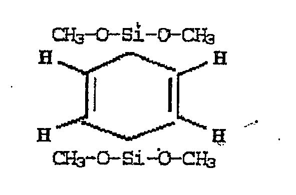 especially as SiC or SiOC precursor.

## Patentansprüche

1. Verfahren zur Bildung einer dielektrischen Schicht mit kleiner Dielektrizitätskonstante, die zur Trennung von metallischen Leiterbahnen bei der Herstellung von integrierten Schaltungen geeignet ist, wobei die Schicht SiC und/oder SiOC umfaßt und aus mindestens einem Vorläufer erhalten wird, welcher mindestens ein cyclisches Molekül aus einer der folgenden Familien umfaßt: 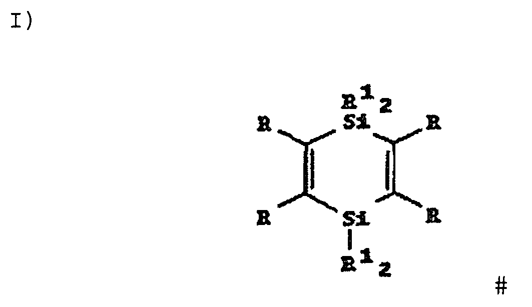 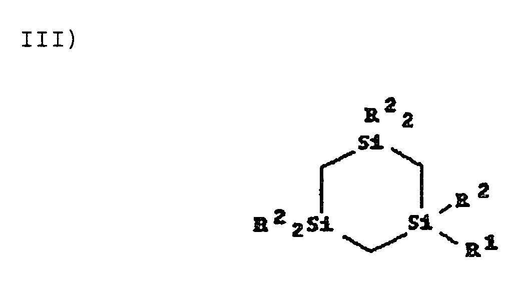 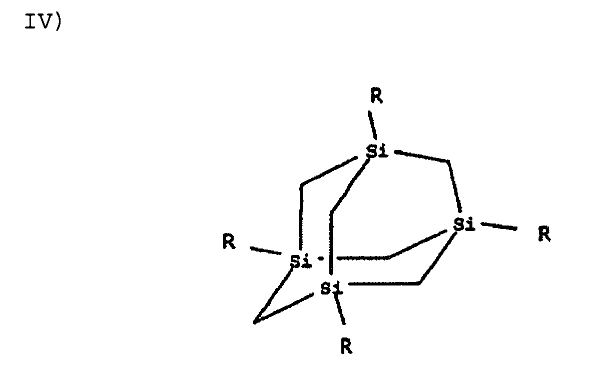 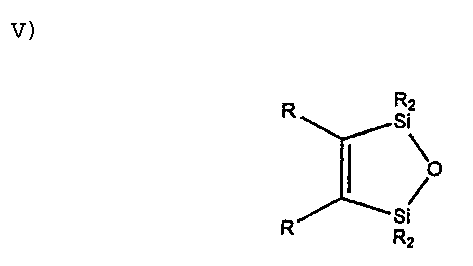 wobei R, R¹ und R² unter Wasserstoff, linearen und/oder cyclischen Kohlenstoffketten wie Alkylen, Arylen oder Alkoxiden ausgewählt sind, **dadurch gekennzeichnet, daß** der Vorläufer verdampft wird, wobei man eine Quelle von verdampftem Vorläufer erhält, die in einen Vakuumabscheidungsreaktor eingebracht wird, in dem ein vorher auf eine Temperatur T gebrachtes Substrat angeordnet ist, so daß sich ein dielektrischer Film mit der gewünschten Endzusammensetzung ergibt.

2. Verfahren nach Anspruch 1, **dadurch gekennzeichnet, daß** es sich bei dem cyclischen Molekül um das doppelte DMDMOS der Formel I, worin R = H und R¹ = R² = -O-CH₃ handelt.

3. Verfahren nach Anspruch 1, **dadurch gekennzeichnet, daß** R für einen Alkylrest, vorzugsweise -CH₃, steht und R¹ = -O-CH₃.

4. Verfahren nach einem der Ansprüche 1 bis 3, **dadurch gekennzeichnet, daß** die die Siliciumatome verbindende Kohlenstoffkette mindestens eine Doppelbindung aufweist.

5. Verfahren nach einem der Ansprüche 1 bis 4, **dadurch gekennzeichnet, daß** man außerdem Stickstoff und/oder ein anderes Inertgas in den Reaktor einleitet.

6. Verfahren nach einem der Ansprüche 1 bis 5, **dadurch gekennzeichnet, daß** man auch Sauerstoff in den Reaktor einleitet, so daß sich eine SiOC-Schicht ergibt.

7. Verwendung des Moleküls der allgemeinen Formel: 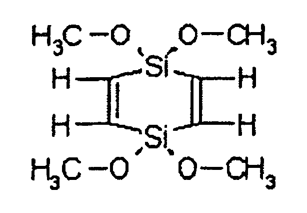 als Vorläufer, insbesondere SiC- und SiOC-Vorläufer.
